(19) **Europäisches Patentamt**

**European Patent Office**

**Office européen des brevets**

(11) **EP 1 318 598 B1**

(12) **EUROPÄISCHE PATENTSCHRIFT**

(45) Veröffentlichungstag und Bekanntmachung des Hinweises auf die Patenterteilung:
**06.05.2004 Patentblatt 2004/19**

(51) Int Cl.⁷: **H03C 3/09**

(21) Anmeldenummer: **01811194.8**

(22) Anmeldetag: **07.12.2001**

(54) **Modulator unter Verwendung eines Phasenregelkreises und Verfahren dazu**

Modulator using a phase lock loop, and process

Modulateur utilisant une boucle à verrouillage de phase, et procédé

(84) Benannte Vertragsstaaten:
**AT BE CH CY DE DK ES FI FR GB GR IE IT LI LU MC NL PT SE TR**

(43) Veröffentlichungstag der Anmeldung:
**11.06.2003 Patentblatt 2003/24**

(73) Patentinhaber: **Aastra Technologies Limited Concord, Ontario L4K 4N9 (CA)**

(72) Erfinder: **Bolliger, Urs 4553 Subingen (CH)**

(74) Vertreter: **Rutz, Peter
RUTZ ISLER & PARTNER
Alpenstrasse 14
Postfach 4627
6304 Zug (CH)**

(56) Entgegenhaltungen:
**EP-A- 0 961 412          WO-A-94/10747
DE-A- 4 317 111          GB-A- 2 160 726
US-B1- 6 268 780**

**Beschreibung**

Die Erfindung betrifft einen Phasenregelkreis mit modulierbarem Ausgangssignal sowie ein Verfahren zu dessen Betrieb und ein Kommunikationsgerät mit einem Phasenregelkreis nach dem Oberbegriff des Patentanspruchs 1, 10 bzw. 15.

Ein in der Nachrichtentechnik besonders wichtiger Anwendungsfall der Regelungstechnik ist die Nachlaufsynchronisation mittels Phasenregelkreisen (Phase-Locked Loop, PLL).

Das Prinzip des Phasenregelkreises ist in [1], U. Tietze, CH. Schenk, Halbleiter-Schaltungstechnik, 11. Auflage, 1. Nachdruck, Springer Verlag, Heidelberg 1999, Seiten 1284-1295 und in [2], Richard C. Dorf, THE ELECTRICAL ENGINEERING HANDBOOK, CRC Press LLC, Boca Raton 1997, Kapitel 76, Seiten 1727-1735, sowie in [3], Roland Best, Theorie und Anwendungen des Phase-locked Loops, 5. Auflage, AT Verlag, Aarau 1993, Kapitel 1, Seiten 9-14 beschrieben.

Die Aufgabe der Nachlaufsynchronisation besteht darin, die Frequenz eines spannungs- oder stromgesteuerten Oszillators, nachstehend Nachlaufoszillator genannt, so einzustellen, dass sie oder gegebenenfalls ein daraus gebildeter Bruchteil mit einer von einem Bezugsoszillator abgegebenen Referenzfrequenz übereinstimmt.

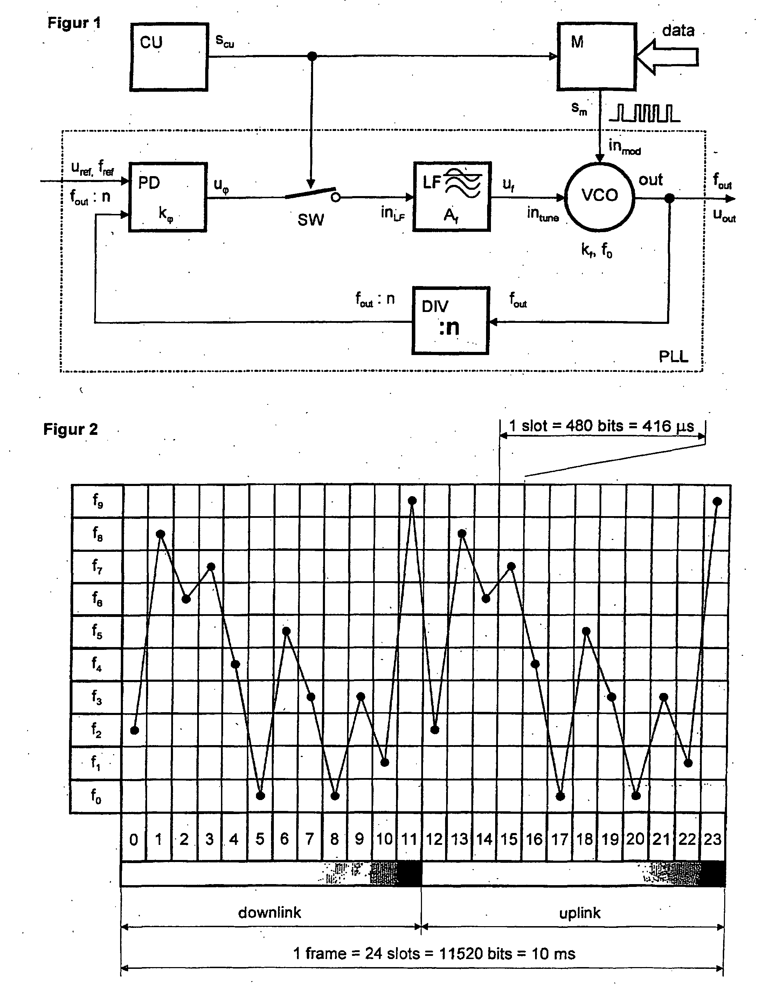

Ein Phasenregelkreis, wie er nachstehend in Figur 1 gezeigt und in [1], Seite 1284 beschrieben ist, besteht grundsätzlich aus drei Funktionseinheiten, nämlich dem bereits erwähnten Nachlaufoszillator VCO, einem Phasendetektor PD und einem Schleifenfilter LF. Die Funktionen des im gezeigten Phasenregelkreis PLL zusätzlich vorgesehenen Schalters SW und des Frequenzteiler DIV werden später beschrieben. Für die anschliessenden Betrachtungen wird angenommen, dass der Schalter SW geschlossen und der Divisor n des Frequenzteilers DIV gleich 1 gesetzt ist.

Der Nachlaufoszillator VCO, der einen Verstärkungsfaktor $k_f$ und eine Mittenfrequenz $f_0$ aufweist, schwingt mit einer Frequenz $f_{out}$, die durch das Ausgangssignal $u_f$ des Schleifenfilters LF, die sogenannte Stellgrösse, wie folgt bestimmt wird:

$$f_{out} = f_0 + k_f * u_f$$

Der Phasendetektor PD, der einen Verstärkungsfaktor $k\varphi$ aufweist, liefert eine Ausgangsspannung $u\varphi$, die sogenannte Regelgrösse, die von der Phasenverschiebung $\varphi$ zwischen dem Ausgangssignal $u_{out}$ des Nachlaufoszillators VCO und dem Ausgangssignal $u_{ref}$ des Bezugsoszillators wie folgt bestimmt wird:

$$u\varphi = k\varphi * \varphi$$

Für das Ausgangssignal $u_f$ des Schleifenfilters LF, das einen Verstärkungsfaktor $A_R$ aufweist, gilt:

$$u_f = A_R * u\varphi$$

Bei geschlossenem Regelkreis wird die Frequenz $f_{out}$ des Nachlaufoszillators VCO daher stets der Frequenz des Bezugsoszillators nachgeführt, wobei die Regelabweichung der Phase $\varphi$ normalerweise nicht Null wird.

Wie in [1], Seiten 1294 und 1295 beschrieben, kann der Phasenregelkreis PLL durch Zuschaltung des nachstehend in Figur 1 gezeigten Frequenzteilers DIV zu einem Frequenzvervielfacher ergänzt werden, der nach Einstellung eines entsprechenden Divisors n eine gewünschte Frequenz $f_{out}$ erzeugt.

Phasenregelkreise können daher vorteilhaft in Übertragungssystemen verwendet werden, in denen Sprachsignale und Daten mittels Trägerfrequenzen übertragen werden. In Übertragungssystemen, in denen Frequenzmultiplexverfahren oder Mehrfachzugriffsverfahren angewendet werden, erlauben Phasenregelkreise die Einstellung sowie die rasche Umschaltung der verwendeten Trägerfrequenzen.

Frequenzmultiplexverfahren oder Mehrfachzugriffsverfahren sind z.B. in [4], Jerry D. Gibson, THE COMMUNICATIONS HANDBOOK, CRC PRESS, Boca Raton 1997, Kapitel 7, Seiten 87-93 und Kapitel 46.3, Seiten 630-644 beschrieben. [4], Kapitel 86, Seiten 1208-1212, Tabelle 86.1 gibt eine Übersicht über diesbezügliche Charakteristiken der in digitalen Mobilfunksystemen angewendeten Übertragungsverfahren.

In [5], WO 94/10747 ist beschrieben, dass Phasenregelkreise, die der Frequenzstabilisierung eines Trägersignals dienen, gleichzeitig die Modulation des Trägersignals erlauben. Dabei wird vorausgesetzt, dass die Regelfrequenz des Phasenregelkreises erheblich unter der Frequenz der Modulationssignale, Sprachsignalen oder digitalen Signalen, liegt, da ansonsten der Phasenregelkreis die durch die Modulationssignale hervorgerufenen Frequenzänderungen kompensieren würde. Da bei einer Vielzahl von Kommunikationsendeinrichtungen jedoch hohe Regelfrequenzen erforderlich sind, um die Einschwinggeschwindigkeit des Phasenregelkreises zu verkürzen, wird in [5] vorgeschlagen, den Phasenregelkreis während des Modulationsvorganges zu unterbrechen, so dass die durch die Modulation verursachte Phasenverschiebung $\varphi$ zwischen dem Ausgangssignal $u_{out}$ des Nachlaufoszillators VCO und dem Ausgangssignal $u_{ref}$ des Bezugsoszillators nicht ausgeregelt wird.

Wie in Figur 1 gezeigt kann der Phasenregelkreis mittels eines Schalters SW unterbrochen werden, wonach an einem ersten Eingang $in_{tune}$ des Nachlaufoszillators VCO das zur Einstellung der Frequenz $f_{out}$ dienende Ausgangssignal des Schleifenfilters LF, nämlich die Spannung $u_f$, anliegt und über einen zweiten Eingang $in_{mod}$ ein Modulationssignal $s_m$ zuführbar ist. Wie

in [5], Figur 2 gezeigt, können das Modulationssignal $s_m$ und das Ausgangssignal $u_f$ des Schleifenfilters LF auch in einer Additionsstufe summiert und nur einem Eingang des Nachlaufoszillators VCO zugeführt werden. Meist ist es jedoch von Vorteil einen Nachlaufoszillator VCO mit zwei Eingängen $in_{tune}$ und $in_{mod}$ zu verwenden, die unterschiedliche Steilheiten aufweisen.

Die als Stellgrösse dienende Spannung $u_f$ wird durch die im Schleifenfilter LF vorhandenen Kondensatoren während des Modulationsintervalls weitgehend konstant gehalten, sofern die Regelfrequenz des Phasenregelkreises genügend tief und das Modulationsintervall genügend kurz ist. Bei Phasenregelkreisen, die für eine hohe Regelfrequenz ausgelegt und daher mit kleinen Kapazitäten im Schleifenfilter LF versehen sind, entsteht während des Modulationsintervalls hingegen eine deutliche Änderung der Spannung $u_f$ am Ausgang des Schleifenfilters LF, so dass die eingestellte Frequenz $f_{out}$ innerhalb des Modulationsintervalls erheblich ändert und Übertragungsprobleme entstehen können.

Die Verwendung bekannter Phasenregelkreise in Kommunikationssystemen, wie dem DECT-System, das in [6], B. Walke, Mobilfunknetze und ihre Protokolle, Band 2, Teubner Verlag, Stuttgart 2000, Kapitel 5.3, Seiten 122-145 beschrieben ist, führt daher dazu, dass die in den Spezifikationen dieser Systeme festgelegten Kanalkapazitäten gegebenenfalls nicht voll ausgeschöpft werden können.

Wie nachstehend in Figur 2 gezeigt, hat das im Frequenzbereich von 1880-1900 MHz arbeitende DECT-System die Möglichkeit, durch das FDMA (Frequency Division Multiple Access) Zugriffsverfahren bei der Kanalwahl zwischen 10 verschiedenen Trägerfrequenzen $f_1$, ..., $f_9$ zu wählen, die wie folgt berechnet werden:

$$f_c = f_0 - c * 1728 \text{ kHz mit } c = 0, 1, 2, ..., 9 \text{ und}$$
$$f_0 = 1897{,}344 \text{ MHz}$$

Dabei soll die Abweichung von der Mittenfrequenz im aktiven Zustand maximal ± 50 kHz betragen.

Als Modulationsverfahren wird in DECT-Systemen entweder ein Gaussian Frequency Shift Keying (GFSK) oder ein Gaussian Minimum Shift Keying (GMSK) angewendet. Die Übertragung einer binären 1 führt dabei zu einer Frequenzerhöhung um $\Delta f = 288$kHz auf $f_c + 288$ kHz. Für die Aussendung einer 0 wird die Frequenz um $\Delta f$ auf $f_c - 288$ kHz erniedrigt.

In DECT-System wird ferner das TDMA (Time Division Multiple Access)-Zugriffsverfahren angewendet, gemäss dem, wie nachstehend in Figur 2 gezeigt, die Übertragungskapazität jeder Trägerfrequenz in 10 ms lange, periodisch auftretende Rahmen (Frames) unterteilt wird, innerhalb denen in 24 Zeitschlitzen je 480 Datenbits übertragbar sind. Die ersten zwölf Zeitschlitze dienen bei der normalerweise eingesetzten Basic Connection zur Datenübertragung von einer Feststation zu Mobilstationen (Down-link), während die zweiten zwölf Zeitschlitze zur Datenübertragung von den Mobilstationen zur Feststation reserviert sind (Up-link).

Um alle Zeitschlitze ausnützen und somit die ganze Kanalkapazität voll ausschöpfen zu können, ist es dabei erforderlich, dass die Trägerfrequenzen innerhalb von etwa 40 μs umgeschaltet werden, wobei bei der Einstellung der Frequenz und während des Modulationsintervalls die maximal zulässige Mittenfrequenzabweichung einzuhalten ist.

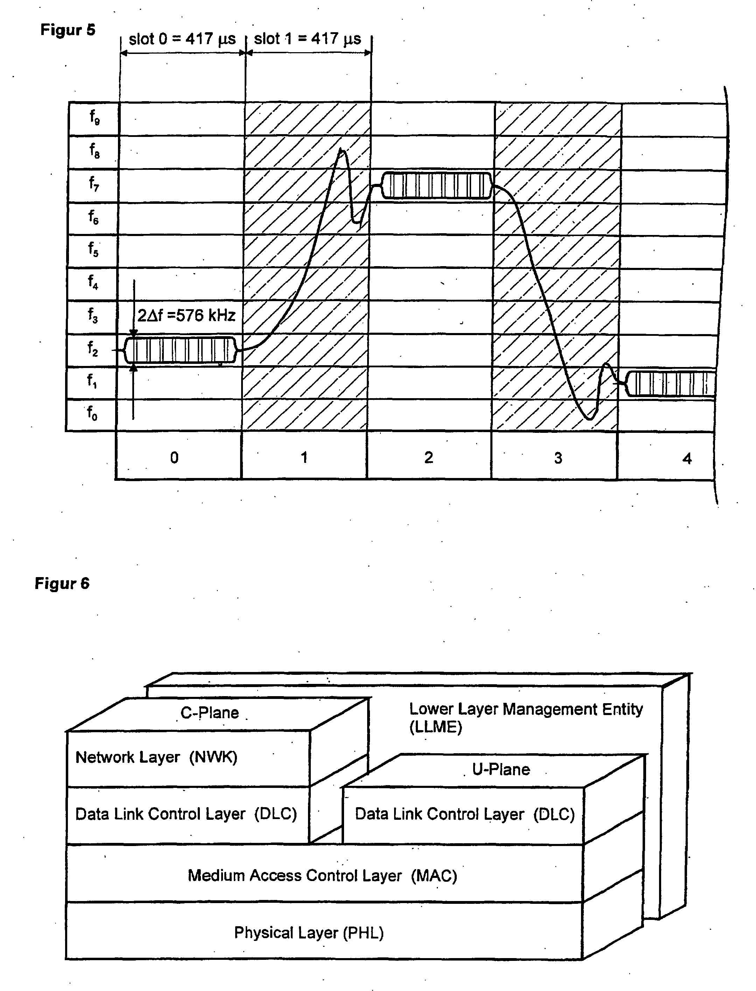

Mit den oben beschriebenen Phasenregelkreisen lassen sich diese Forderungen kaum erfüllen, so dass in der Praxis normalerweise das sogenannte Blind-Slot-Verfahren angewendet wird, bei dem, wie in Figur 5 gezeigt, nach der Übertragung von Daten innerhalb eines Zeitschlitzes jeweils der nächste Zeitschlitz zum Umschalten der Trägerfrequenz $f_{out}$ verwendet wird. Die Regelfrequenz des Phasenregelkreises kann daher tief gehalten werden, so dass während des Modulationsintervalls, bei geöffneter Regelschleife keine störende Änderung der Ausgangsspannung $u_f$ des Schleifenfilters und somit der eingestellten Trägerfrequenz $f_{out}$ entsteht. Nachteilig hingegen ist, dass beim Blind-Slot-Verfahren nur die Hälfte der vorhandenen Kanalkapazität genutzt wird.

Der vorliegenden Erfindung liegt daher die Aufgabe zugrunde, einen verbesserten Phasenregelkreis zu schaffen, bei dem erzeugte Trägerfrequenzen bei geschlossener Regelschleife schneller umschaltbar sind und eingestellte Trägerfrequenzen bei geöffnetem Regelkreis, innerhalb von Modulationsintervallen, eine höhere Stabilität aufweisen. Ferner ist ein Verfahren zum Betrieb dieses Phasenregelkreises anzugeben, der eingesetzt in Kommunikationsgeräten, wie Festoder Mobilstationen eines DECT-Systems, das volle Ausschöpfen vorhandener Systemkapazitäten erlauben soll.

Die Lösung dieser Aufgabe gelingt mit einem Phasenregelkreis nach Anspruch 1, einem Verfahren zum Betrieb dieses Phasenregelkreises nach Anspruch 10 und einem Kommunikationsgerät nach Anspruch 15. Vorteilhafte Ausgestaltungen der Erfindung sind in weiteren Ansprüchen angegeben.

Der Phasenregelkreis weist einen Nachlaufoszillator auf, dessen Ausgangssignal $f_{out}$, das bei geöffnetem Regelkreis modulierbar ist, in einem Phasendetektor mit einem Referenzsignal $f_{ref}$ verglichen wird, dessen Ausgangssignal $u\varphi$ über einen der Öffnung des Regelkreises dienenden Schalter sowie ein Schleifenfilter einem ersten Eingang des Nachlaufoszillators zuführbar ist.

Erfindungsgemäss ist eine Kompensationseinheit vorgesehen, von der dem Schleifenfilter oder dem Nachlaufoszillator ein Kompensationssignal, ein Strom oder eine Spannung, zuführbar ist, durch das bei geöffnetem Regelkreis auftretende Signalverschiebungen kompensierbar sind.

Zur Steuerung des Phasenregelkreises wird von einer Steuereinheit ein Steuersignal erzeugt, mittels dessen die Kompensationseinheit, der Schalter sowie eine mit dem ersten oder einem zweiten Eingang des Nachlaufoszillators verbundene Modulationseinheit derart miteinander synchronsierbar sind, dass der Regelkreis für die Dauer des Modulationsintervalls geöffnet und auftretende Signalverschiebungen mittels des Kompensationssignals kompensiert werden.

Das Kompensationssignal, das zum unmittelbaren Ausgleich oder zur Kompensation von Leckströmen dient, die im Schleifenfilter auftreten, wird

a) dem Eingang oder einem Filterbauteil des Schleifenfilters zugeführt, oder

b) einer mit dem ersten Eingang des Nachlaufoszillators verbundenen ersten Additionsstufe zugeführt, in der das Kompensationssignal und das Ausgangssignal $u_f$ des Schleifenfilters summiert werden, oder

c) einer mit dem zweiten Eingang des Nachlaufoszillators verbundenen zweiten Additionsstufe zugeführt, in der das Kompensationssignal und das Ausgangssignal der Modulationseinheit summiert werden.

Das Kompensationssignal ist vorzugsweise eine sich linear ändernde Spannung, die gesteuert durch die Steuereinheit, mittels eines in der Kompensationseinheit vorgesehenen Rampengenerators während des Modulationsintervalls erzeugt und dem Schleifenfilter oder dem Nachlaufoszillator gegebenenfalls über einen Kondensator zugeführt wird.

Die Steilheit der vom Rampengenerator abgegebenen, sich linear ändernden Spannung ist vorzugsweise mittels eines Justiersignals einstellbar, dessen optimaler Wert in einem schnell durchführbaren Abstimmverfahren leicht ermittelt werden kann.

Der Rampengenerator wird vorteilhaft mit einer, beispielsweise anhand von vier gleich grossen Widerständen gebildeten Brückenschaltung mit zwei Brückenzweigen realisiert, deren oberer Anschluss über einen parallel zu einem ersten Schalter geschalteten ersten Kondensator mit einer Betriebsspannung, deren unterer Anschluss über einen parallel zu einem zweiten Schalter geschalteten zweiten Kondensator mit Masse, deren erster Mittelanschluss mit der Stellspannung und deren zweiter Mittelanschluss, an dem die sich linear ändernde Spannung gebildet wird, mit dem Ausgang des Rampengenerators verbunden ist, wobei die beiden Schalter mittels der Steuereinheit für die Dauer des Modulationsintervalls geöffnet werden können.

In einer vorzugsweisen Ausgestaltung ist der Phasenregelkreis zusätzlich mit einer einen Temperaturfühler aufweisenden Temperaturkompensationseinheit versehen, die zur Abgabe einer der Kompensation von Temperatureinflüssen dienenden Korrekturspannung geeignet ist, welche vorzugsweise in einer dritten Additionsstufe mit der Stellspannung summiert und dem Rampengenerator zugeführt wird.

Der erfindungsgemässe Phasenregelkreis, insbesondere dessen Schleifenfilter, kann daher derart ausgestaltet werden, dass bei geschlossener Regelschleife die erzeugten Trägerfrequenzen schneller umschaltbar sind, ohne dass bei geöffneter Regelschleife, innerhalb eines Modulationsintervalls, störende Verschiebungen der eingestellten Trägerfrequenz auftreten. Der Phasenregelkreis ist zudem einfach aufgebaut und kann innerhalb eines kurzen Abstimmvorganges optimal eingestellt werden.

Erfindungsgemässe Phasenregelkreise sind daher vorteilhaft in Geräten von Kommunikationssystemen, insbesondere in Mobilfunkoder drahtlosen Kommunikationssystemen wie dem DECT-System, einsetzbar, in denen zu modulierende Trägerfrequenzen schnell umgeschaltet werden müssen, um die Systemkapazität voll ausschöpfen zu können.

Nachfolgend wird die Erfindung anhand von Zeichnungen näher erläutert. Dabei zeigt :

Figur 1 einen bekannten Phasenregelkreis mit einem Nachlaufoszillator, einem Phasendetektor, einem Schleifenfilter sowie mit einer Modulationseinheit und einem von einer Steuereinheit gesteuerten Schalter, mittels dessen der Regelkreis für die Dauer eines Modulationsintervalls jeweils geöffnet werden kann.

Figur 2 Umschaltungen von Trägerfrequenzen mit der Nutzung aller vorhandenen Zeitschlitze in einer nach den DECT-Spezifikationen arbeitenden Feststation,

Figur 3 die Umschaltvorgänge und die Modulation des Trägersignals in den ersten vier Zeitschlitzen der Darstellung von Figur 2,

Figur 4 Umschaltungen von Trägerfrequenzen, die während Zeitschlitzen erfolgen, die für die Übertragung von Daten daher nicht mehr nutzbar sind,

Figur 5 die Umschaltvorgänge und die Modulation des Trägersignals in den ersten vier Zeitschlitzen der Darstellung von Figur 4,

Figur 6 die Protokollarchitektur des DECT-Systems,

Figur 7 einen erfindungsgemässen Phasenregelkreis mit einer Kompensationseinheit, deren Ausgangssignal dem Schleifenfilter des Phasenregelkreises zugeführt wird,

Figur 8 die Kompensationseinheit von Figur 7 in einer vorzugsweisen Ausgestaltung,

Figur 9 die Kompensationseinheit von Figur 7 in einer weiteren vorzugsweisen Ausgestaltung, mit einem der Erzeugung einer sich linear ändernden Spannung dienenden Rampengenerator,

Figur 10 einen erfindungsgemässen Phasenregelkreis mit einer Kompensationseinheit, deren Ausgangssignal einer mit dem ersten Eingang des Nachlaufoszillators verbundenen ersten Additionsstufe zuführbar ist, in der das Kompensationssignal und das Ausgangssignal des Schleifenfilters summiert werden,

Figur 11 einen erfindungsgemässen Phasenregelkreis mit einer Kompensationseinheit, deren Ausgangssignal einer mit dem zweiten Eingang des Nachlaufoszillators verbundenen zweiten Additionsstufe zuführbar ist, in der das Kompensationssignal und das Ausgangssignal der Modulationseinheit summiert werden,

Figur 12 eine vorzugsweise Ausgestaltung des Rampengenerators von Figur 9,

Figur 13 eine der Erzeugung eines Korrektursignals dienende Temperaturkompensationseinheit und

Figur 14 die Temperaturkompensationseinheit von Figur 13, deren digitales Ausgangssignal $s_{tc}$ mit einem digitalen Justiersignal $s_{adj}$ summiert wird.

Figur 1 zeigt den einleitend beschriebenen Phasenregelkreis PLL, der einen Nachlaufoszillator VCO, einen Phasendetektor PD, ein Schleifenfilter LF und einen der Frequenzvervielfachung dienenden Frequenzteiler DIV aufweist. Der Regelkreis ist ferner mittels eines zwischen dem Phasendetektor PD und dem Schleifenfilter LF angeordneten Schalters SW auftrennbar, der von einer Steuereinheit CU derart steuerbar ist, dass der Regelkreis während Intervallen geöffnet werden kann, in denen dem Nachlaufoszillator VCO von einem Modulator M ein Modulationssignal $s_m$ zugeführt wird.

Der Phasendetektor PD, der einen Verstärkungsfaktor $k\varphi$ aufweist, liefert ein Ausgangssignal $u\varphi$, das von der Phasenverschiebung $\varphi$ zwischen dem Ausgangssignal $u_{out}$ des Nachlaufoszillators VCO und dem Ausgangssignal $u_{ref}$ eines Bezugsoszillators abhängt und das über den Schalter SW dem Eingang $in_{LF}$ des Schleifenfilters LF zugeführt wird. Der Nachlaufoszillator VCO, der einen Verstärkungsfaktor $k_f$ und eine Mittenfrequenz $f_0$ aufweist, schwingt mit einer Frequenz $f_{out}$, die durch die Spannung $u_f$ am Ausgang des Schleifenfilters LF bestimmt wird. Bei geschlossenem Regelkreis wird die Frequenz $f_{out}$ des Nachlaufoszillators VCO daher stets der Frequenz des Bezugsoszillators nachgeführt. Nach der Öffnung des Schalters SW folgt die Frequenz $f_{out}$ des Nachlaufoszillators VCO hingegen, unabhängig von den Ausgangssignalen $u_{out}$, $u_{ref}$ des Nachlaufoszillators VCO und des Bezugsoszillators, ausschliesslich dem Verlauf der Spannung $u_f$ am Ausgang des Schleifenfilters LF.

Die Spannung $u_f$ wird durch die im Schleifenfilter LF vorhandenen Kapazitäten während des Modulationsintervalls ausreichend stabil gehalten, sofern die Regelfrequenz des Phasenregelkreises genügend tief und das Modulationsintervall genügend kurz ist. Bei Phasenregelkreisen, die für eine hohe Regelfrequenz ausgelegt und daher mit kleinen Kapazitäten im Schleifenfilter LF versehen sind, entsteht während des Modulationsintervalls hingegen eine deutliche Änderung der Spannung $u_f$ am Ausgang des Schleifenfilters LF, so dass die eingestellte Frequenz $f_{out}$ innerhalb des Modulationsintervalls erheblich ändert und Übertragungsprobleme entstehen können.

Derartige Phasenregelkreise sind daher nicht in der Lage, die Anforderungen moderner Kommunikationssysteme zu erfüllen, die einerseits ein sehr schnelles Umschalten der Trägerfrequenzen und andererseits eine hohe Stabilität der eingestellten Trägerfrequenzen während den Modulationsintervallen vorschreiben.

Figur 2 zeigt die Umschaltung von Trägerfrequenzen mit der Nutzung aller vorhandenen Zeitschlitze in einem DECT (Digital Enhanced Cordless Telecommunication) System (siehe [6], Seiten 107 und 108).

Gemäss dem in Figur 6 gezeigten DECT-Referenzmodell (siehe [6], Seite 123) ist die Physikalische Schicht für die Realisierung von Übertragungskanälen über das Funkmedium verantwortlich, das normalerweise von vielen Mobilstationen gleichzeitig genutzt wird. Interferenzen zwischen kommunizierenden Festund Mobilstationen werden durch eine dezentral organisierte Nutzung der verfügbaren Dimensionen: Ort, Zeit und Frequenz weitgehend vermieden. Wie einleitend beschrieben, wird in DECT-Systemen bezüglich der Zeitdimension das TDMA-Verfahren und bezüglich der Frequenzdimension das FDMA-Verfahren angewendet.

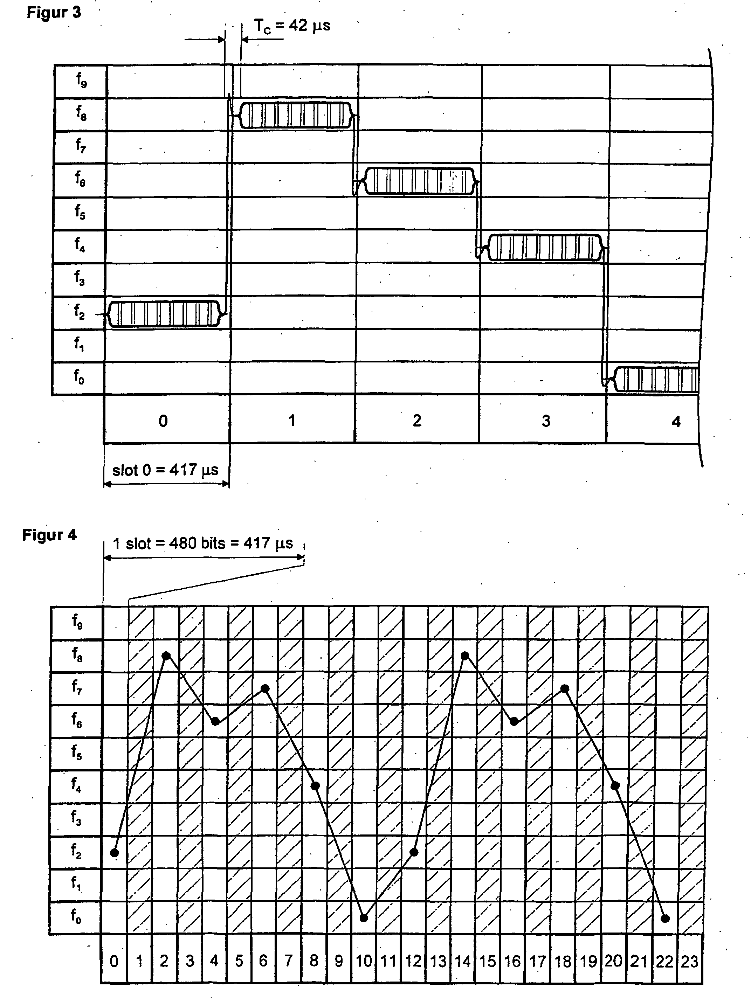

Aus Figur 3 ist ersichtlich, dass bei der Anwendung dieser Verfahren die Zeit zum Umschalten der Trägerfrequenz zwischen zwei aneinander anschliessenden Zeitschlitzen sehr kurz im Verhältnis zur Länge der Zeitschlitze ist, während denen die eingestellten Trägerfrequenzen stabil zu halten ist.

Da die bekannten Phasenregelkreise die Forderungen nach kurzen Umschaltzeiten und gleichzeitiger Stabilität der eingestellten Trägerfrequenz innerhalb relativ langer Modulationsintervalle nicht zu erfüllen vermögen, wird oft das sogenannte Blind-Slot-Verfahren angewendet, bei dem, wie in Figur 4 gezeigt, Zeitschlitze alternierend für die Übertragung von Daten und die Umschaltung der Frequenz verwendet werden. Wie in Figur 5 beispielsweise gezeigt, werden innerhalb der geradzahligen Zeitschlitze Daten übertragen, während die ungeradzahligen Zeitschlitze zur Umschaltung der Trägerfrequenzen verwendet werden.

Alternativ ist auch der Einsatz von zwei Hochfrequenzeinheiten möglich, mittels denen die Trägerfrequenzen alternierend eingestellt werden. Bei dieser Lösung resultiert jedoch ein deutlich höherer Herstellungsaufwand.

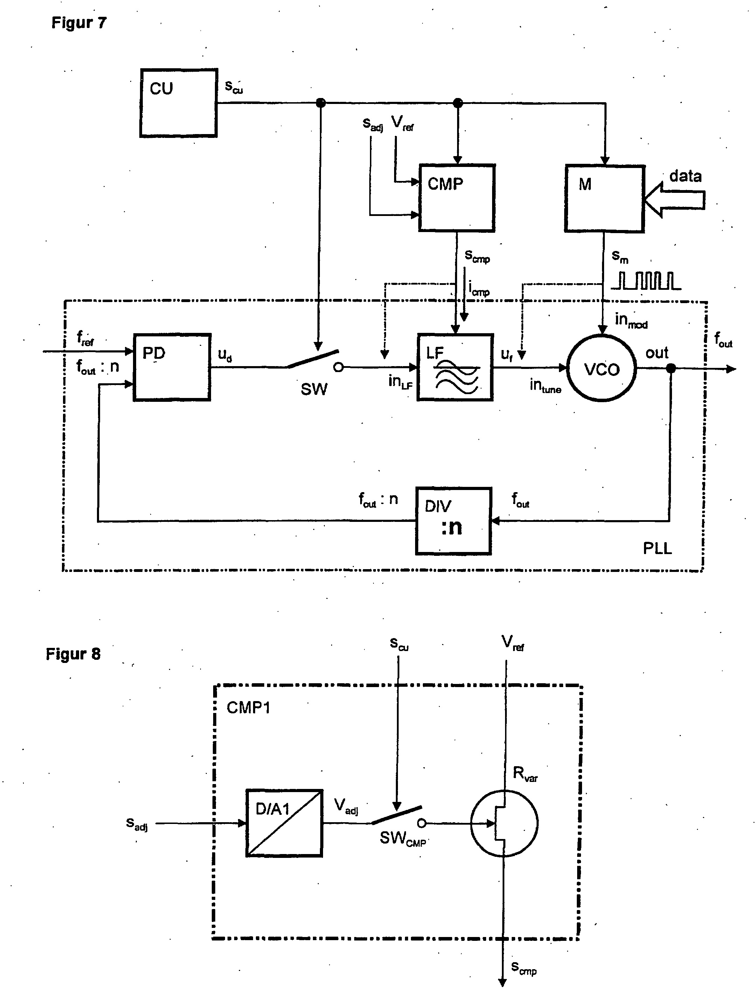

Figur 7 zeigt einen erfindungsgemässen Phasenregelkreis, der eine Kompensationseinheit CMP aufweist, die zur Erzeugung eines Kompensationssignals $s_{cmp}$ dient, durch das bei geöffnetem Regelkreis auftretende Signalverschiebungen kompensierbar sind. Das Kompensationssignal $s_{cmp}$ wird von der Kompensationseinheit CMP an das Schleifenfilter LF, vorzugsweise an dessen Eingang $in_{LF}$ oder an ein darin enthaltenes Filterbauteil abgegeben. Beispielsweise wird das Kompensationssignal $s_{cmp}$ einem Filter-Kondensator zugeführt, um Ladungsverluste auszugleichen, die während des Modulationsintervalls auftreten.

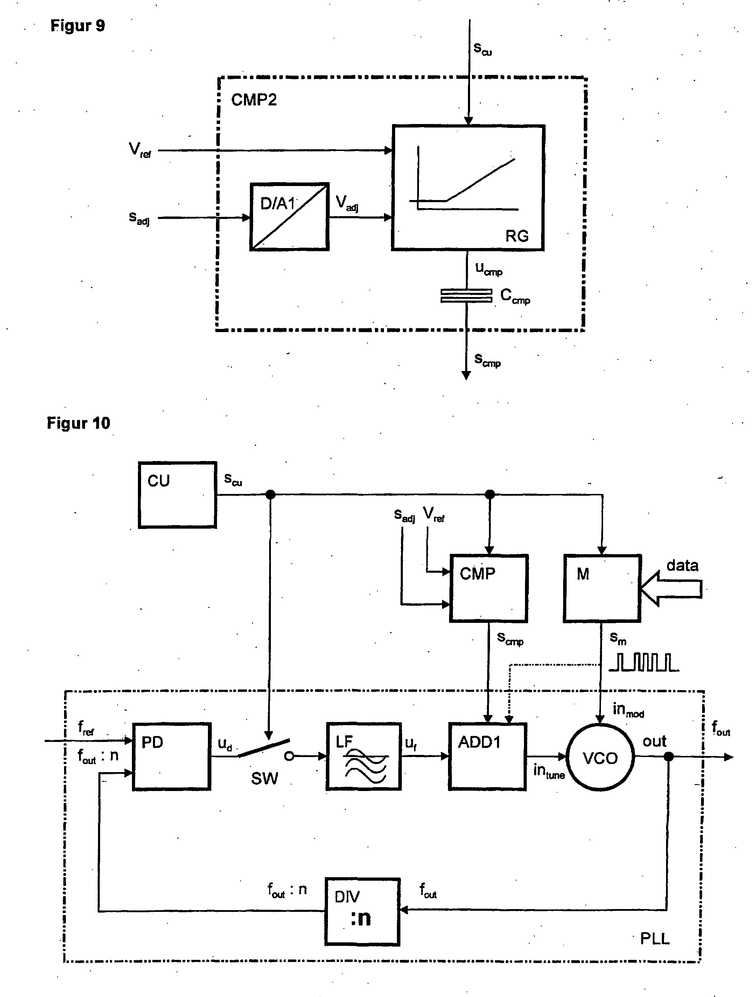

Zum Ausgleich von Ladungsverlusten wird dem Schleifenfilter LF vorzugsweise ein konstanter Strom $i_{cmp}$ zugeführt, welcher das Ausgangssignal $u_f$ des Schleifenfilters LF stabilisiert. Wie nachfolgend beschrieben, wird in einer vorzugsweisen Ausgestaltung der Erfindung dazu eine sich linear ändernde Spannung erzeugt, die an einen Kondensator $C_{cmp}$ angelegt wird, der in der Folge einen konstanten Strom an das Schleifenfilter LF abgibt (siehe Figur 9).

Die Kompensationseinheit CMP wird mit der mit dem ersten oder einem zweiten Eingang $in_{tune}$, $in_{mod}$ des Nachlaufoszillators VCO verbundenen Modulationseinheit M und dem Schalter SW mittels eines von der Steuereinheit CU abgegebenen Steuersignals $s_{cu}$ synchronisiert, welches den Verlauf der Modulationsintervalle anzeigende Flanken aufweist. Der Kompensationseinheit CMP wird ferner eine Referenzspannung $V_{ref}$ sowie eine Justierspannung $V_{adj}$ zugeführt, mittels der das Kompensationssignal $s_{cmp}$ entsprechend den in der Schaltung auftretenden Signalverschiebungen bzw. den Leckströmen, die die Signalverschiebungen verursachen, angepasst werden kann.

Die Abstimmung der Schaltung kann nach deren Herstellung oder Einbau in ein Gerät anhand von wenigen Messungen, mittels denen die Stabilität des Ausgangssignals $u_f$ des Schleifenfilters LF oder vorzugsweise die Stabilität der eingestellten Trägersignale $f_{out}$ bei geöffneter Regelschleife geprüft wird, in einfacher Weise erfolgen.

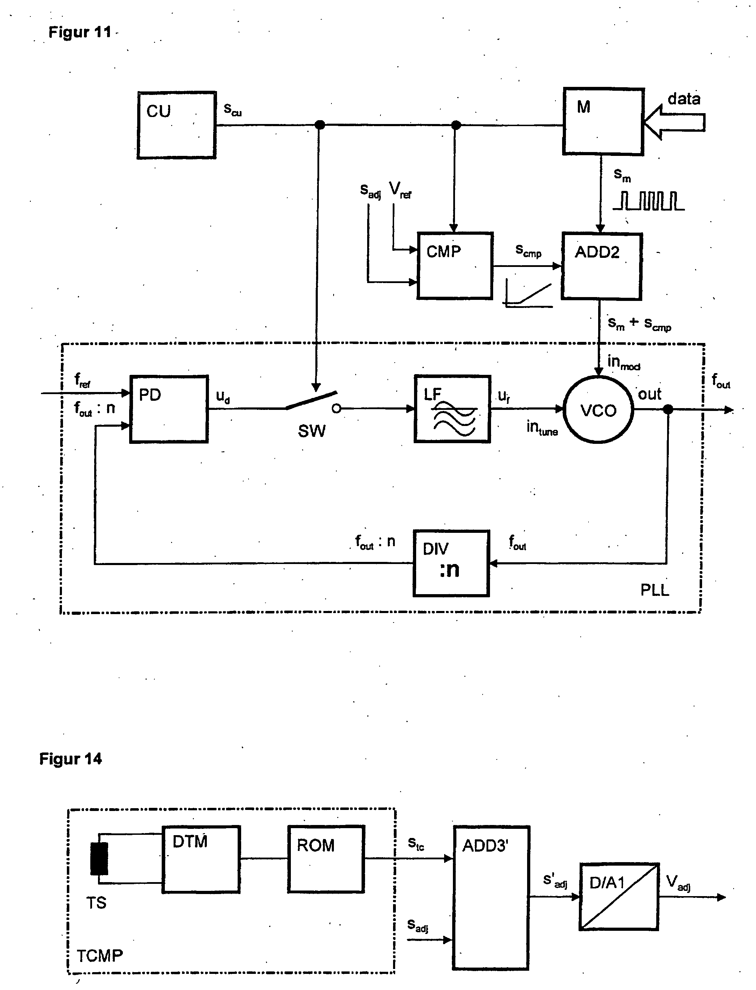

Wie in Figur 10 und Figur 11 gezeigt, kann das Kompensationssignal $s_{cmp}$ auch dem Ausgangssignal $u_f$ des Schleifenfilters LF oder dem Ausgangssignal $s_m$ des Modulators M überlagert werden.

In der Schaltungsanordnung von Figur 10 ist dazu eine mit dem ersten Eingang $in_{tune}$ des Nachlaufoszillators VCO verbundene erste Additionsstufe ADD1 vorgesehen, in der das Kompensationssignal $s_{cmp}$ und das Ausgangssignal $u_f$ des Schleifenfilters LF summiert werden. Vorzugsweise besteht die Additionsstufe ADD1 aus einem Widerstandsnetzwerk, dem das Ausgangssignal $u_f$ des Schleifenfilters LF und ein Kompensationsstrom $i_{cmp}$ zugeführt werden, der beispielsweise von dem in Figur 9 gezeigten Kondensator $C_{cmp}$ abgegeben wird, dem die Ausgangsspannung $u_{cmp}$ des Rampengenerators RG zugeführt wird.

In der Schaltungsanordnung von Figur 11 ist eine mit dem zweiten Eingang $in_{mod}$ des Nachlaufoszillators VCO verbundene zweite Additionsstufe ADD2 vorgesehen, in der das Kompensationssignal $s_{cmp}$, vorzugsweise die vom Rampengenerator RG abgegebene Kompensationsspannung $u_{cmp}$, und das Ausgangssignal $s_m$ der Modulationseinheit M summiert werden.

Der erste Eingang $in_{tune}$, über den die Trägerfrequenzen $f_c$ einstellbar sind, und der zweite Eingang $in_{mod}$ des Nachlaufoszillators VCO, über den die eingestellten Trägerfrequenzen $f_c$ modulierbar sind, weisen dabei unterschiedliche Steilheiten auf, so dass das Kompensationssignal $s_{cmp}$ entsprechend anzupassen ist. Sofern das Ausgangssignal $s_m$ der Modulationseinheit M dem ersten Eingang $in_{tune}$ des Nachlaufoszillators VCO zugeführt wird, so ist dieses entsprechend zu reduzieren.

Figur 8 und Figur 9 zeigen den Aufbau von Kompensationseinheiten CMP1, CMP2, die zur Abgabe von Kompensationssignalen $s_{cmp}$, Spannungen oder Strömen, geeignet sind.

In der in Figur 8 gezeigten Kompensationseinheit CMP1 wird ein digitales Justiersignal $s_{adj}$ einem Digital/Analog-Wandler D/A1 zugeführt, der eine entsprechende Stellspannung $V_{adj}$ über einen von der Steuereinheit CU steuerbaren Schalter $SW_{CMP}$ dem Steuereingang eines variablen Widerstandes $R_{var}$ zuführt, der mit einer Referenzspannung $V_{ref}$ verbunden ist. Der variable Widerstand $R_{var}$ kann dabei auf einen vorbestimmten Wert eingestellt oder während des Modulationsintervalls entsprechend einem festgelegten Widerstandverlauf geändert werden.

In der in Figur 9 gezeigten Kompensationseinheit CMP2 wird die vom Digital/Analog-Wandler D/A1 abgegebene Stellspannung $V_{adj}$ einem Rampengenerator RG zugeführt, der nach Erhalt eines entsprechenden Steuersignals $s_{cu}$ eine sich linear ändernde, den Verlauf einer Rampe bildende Spannung $u_{cmp}$ erzeugt, die einem mit dem Schleifenfilter LF oder mit der ersten Additionsstufe ADD1 verbundenen Kondensator $C_{cmp}$ oder der zweiten Additionsstufe ADD2 zugeführt wird.

Die sich linear ändernde Spannung $u_{cmp}$ bewirkt im Kondensator $C_{cmp}$ einen konstanten Strom, durch den im Schleifenfilter LF auftretende Leckströme ausgeglichen werden.

Sofern, die sich linear ändernde Spannung $u_{cmp}$ in der zweiten Additionsstufe ADD2 mit dem Ausgangssignal $s_m$ der Modulationseinheit M summiert wird, so erfolgt eine Stabilisierung des eingestellten Trägersignals $f_c$ durch eine entsprechende Spannungsänderung am zweiten Eingang in$_{mod}$ des Nachlaufoszillators VCO.

Die Steilheit der vom Rampengenerator RG erzeugten, sich linear ändernden Spannung u$_{cmp}$ ist mittels des Justiersignals s$_{adj}$ einstellbar, so dass allfällige Signalverschiebungen präzise kompensiert werden können.

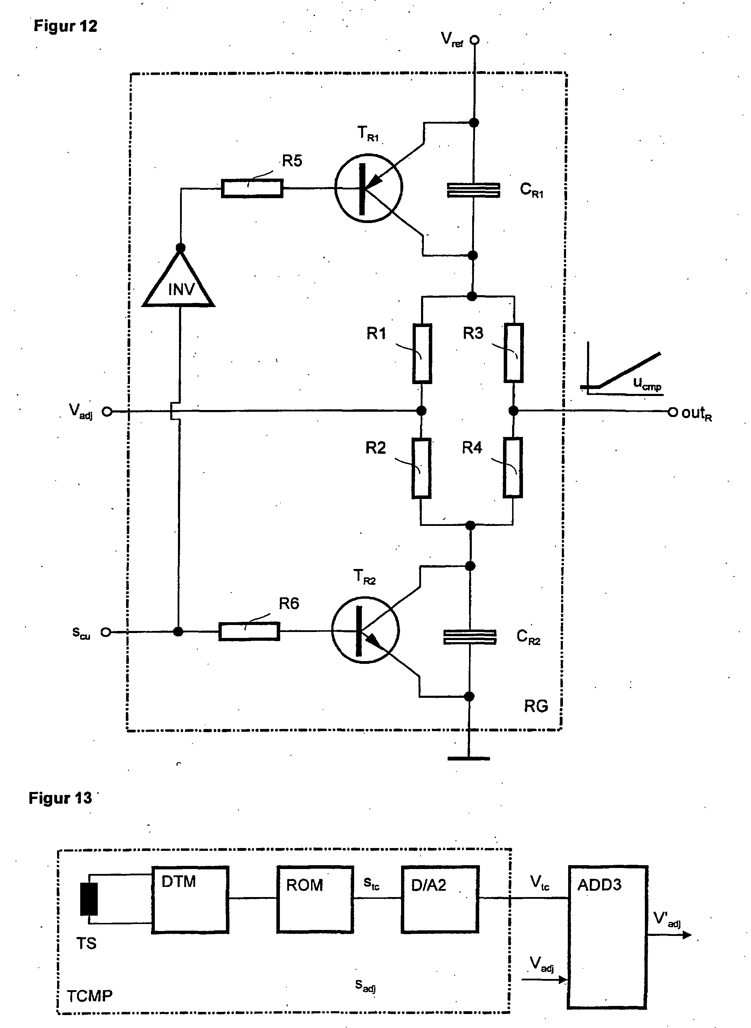

Figur 12 zeigt den Rampengenerator RG von Figur 9 in einer vorzugsweisen Ausgestaltung. Der gezeigte Rampengenerator RG weist eine Brückenschaltung mit einem aus zwei Widerständen R1, R2 gebildeten ersten Brückenzweig und einem aus zwei weiteren Widerständen R3, R4 gebildeten zweiten Brückenzweig, die an deren Enden miteinander verbunden sind und dort einen unteren und einen oberen Anschluss bilden. Der obere Anschluss ist über einen ersten Kondensator C$_{R1}$ mit der Betriebsspannung V$_{ref}$ und der untere Anschluss ist über einen zweiten Kondensator C$_{R2}$ mit Masse verbunden. Der in Figur 12 gezeigte Rampengenerator RG ist in der Lage, linear steigende oder linear fallende Kompensationssignale s$_{cmp}$ zu erzeugen. Die Schaltung kann vereinfacht aufgebaut werden, wenn die Änderung jeweils in dieselbe Richtung erfolgt.

Dem Mittelanschluss des ersten Brückenzweiges R1, R2 wird die Stellspannung V$_{adj}$ zugeführt, während der Mittelanschluss des zweiten Brückenzweiges, an dem die sich linear ändernde Spannung u$_{cmp}$ gebildet wird, mit dem Ausgang out$_R$ des Rampengenerators RG verbunden ist.

Parallel zu jedem Kondensator C$_{R1}$, C$_{R2}$ ist je ein elektronischer Schalter T$_{R1}$, T$_{R2}$ geschaltet, der es erlaubt, den zugehörigen Kondensator C$_{R1}$; C$_{R2}$ bedarfsweise zu entladen. Zu diesem Zweck ist den Steuereingängen der Schalter T$_{R1}$, T$_{R2}$ über einen Widerstand R6 bzw. über einen Inverter INV und einen Widerstand R5 das Steuersignal s$_{cu}$ von der Steuereinheit CU zuführbar, durch das die Schalter T$_{R1}$, T$_{R2}$ jeweils für die Dauer der Modulationsintervalle geöffnet und anschliessend wieder geschlossen werden.

Sofern die Brückenwiderstände R1, R2, R3, R4 den gleichen Wert aufweisen, funktioniert die Schaltung wie folgt.

Zeitlich ausserhalb der Modulationsintervalle sind die Schalter T$_{R1}$, T$_{R2}$ geschlossen, so dass am Mittelabgriff des zweiten Brückenzweiges R3, R4 stets die halbe Referenzspannung V$_{ref}$/2 auftritt. Eine Beeinflussung der Vorgänge innerhalb des zu dieser Zeit geschlossenen Phasenregelkreises wird daher vermieden.

Nach dem Öffnen der Schalter T$_{R1}$, T$_{R2}$ werden die Kondensatoren C$_{R1}$, C$_{R2}$ in Abhängigkeit der anliegenden Stellspannung V$_{adj}$ geladen. Dabei ist leicht ersichtlich, dass die Kondensatoren C$_{R1}$, C$_{R2}$ symmetrisch geladen werden, solange die dem Mittelanschluss des ersten Brückenzweiges R1, R2 zugeführte Stellspannung V$_{adj}$ den halben Wert der Referenzspannung V$_{ref}$ aufweist (V$_{adj}$ = V$_{ref}$/2). Durch eine Änderung der Stellspannung V$_{adj}$ gegen Nullpotential oder gegen den Wert der Referenzspannung V$_{ref}$ gerät die Brücke aus dem Gleichgewicht, so dass die Kondensatoren C$_{R1}$, C$_{R2}$ asymmetrisch geladen werden und am Mittelanschluss des zweiten Brückenzweiges R3, R4 daher eine linear steigende oder linear fallende Ausgangsspannung u$_{cmp}$ entsteht, mittels der Signalverschiebungen im geöffneten Phasenregelkreis korrigiert werden können.

Die Abstimmung der Schaltung bzw. die Ermittlung des optimalen Wertes der Stellspannung V$_{adj}$ erfolgt, gegebenenfalls nach dem Einbau in ein Gerät, vorzugsweise bei einer durchschnittlich zu erwartenden Betriebstemperatur. Durch äussere Einflüsse bei der späteren Verwendung dieser Geräte können jedoch Betriebstemperaturen auftreten, die von den Durchschnittswerten stark abweichen. Um wiederholte Abstimmungen des Gerätes zu vermeiden, die bei geänderten Betriebsbedingungen der Geräte gegebenenfalls notwendig werden, wird der Phasenregelkreis in einer vorzugsweisen Ausgestaltung mit einer Temperaturkompensationseinheit TCMP versehen, die mittels eines Temperaturfühlers TS die Betriebstemperatur der Schaltung misst.

In Abhängigkeit der gemessenen Temperatur bildet die Temperaturkompensationseinheit TCMP eine Korrekturspannung V$_{tc}$, die wie in Figur 13 gezeigt, beispielsweise in einer dritten Additionsstufe ADD3 mit der Stellspannung V$_{adj}$ summiert und dem Rampengenerator RG zugeführt wird.

In der in Figur 13 gezeigten Schaltungsanordnung ist der Temperaturfühler TS mit einem Digital-Thermometer DTM verbunden, dessen digitales Ausgangssignal einem Codewandler ROM zuführbar ist. Im Codewandler ROM sind Korrekturwerte abgelegt, die zu den auftretenden Messwerten korrespondieren und die in einem zweiten Digital/Analog-Wandler D/A2 in die Korrekturspannung V$_{tc}$ gewandelt werden.

Figur 14 zeigt die Temperaturkompensationseinheit TCMP von Figur 13, deren digitales Ausgangssignal s$_{tc}$ mit einem digitalen Justiersignal s$_{adj}$ in einer Additionsstufe ADD3' summiert wird. Am Ausgang der Additionsstufe ADD3' wird daher ein korrigiertes digitales Justiersignal s'$_{adj}$ abgegeben, das im anschliessenden Digital/Analog-Wandler D/A1 in die Stellspannung V$_{adj}$ umgewandelt wird.

Der erfindungsgemässe Phasenregelkreis wurde in einer bevorzugten Ausgestaltung beschrieben und dargestellt. Anhand der erfindungsgemässen Lehre sind jedoch vielfältige weitere fachmännische Ausgestaltungen des Phasenregelkreises realisierbar. Beispielsweise kann zur Erzeugung des Kompensationssignals s$_{cmp}$ ein anderer Aufbau der beschriebenen Schaltungen gewählt werden. Der Verlauf des Kompensationssignals s$_{cmp}$ kann ferner softwaremässig festgelegt werden, so dass die linear ändernde Spannung u$_{cmp}$ am Ausgang eines Digital/Analog-Wandlers erzeugt werden kann.

Die Verarbeitung digitaler Signale, beispielsweise die Summierung des Ausgangssignals $s_{tc}$ der Temperaturkompensationseinheit TCMP mit einem digitalen Justiersignal $s_{adj}$ erfolgt, vorzugsweise zentralisiert, so dass die betreffenden Additionsstufen ADD3' auch als Softwaremodule realisiert werden können.

Erfindungsgemässe Phasenregelkreise sind vorteilhaft in Geräten von Kommunikationssystemen, insbesondere drahtlosen oder drahtgebundenen Kommunikationsnetzen, beispielsweise in Modulationsstufen von Fest- oder Mobilstationen, einsetzbar.

Literaturverzeichnis

[1] U. Tietze, CH. Schenk, Halbleiter-Schaltungstechnik, 11. Auflage, 1. Nachdruck, Springer Verlag, Heidelberg 1999

[2] Richard C. Dorf, THE ELECTRICAL ENGINEERING HANDBOOK, CRC Press LLC, Boca Raton 1997

[3] Roland Best, Theorie und Anwendungen des Phase-locked Loops, 5. Auflage, AT Verlag, Aarau 1993

[4] Jerry D. Gibson, THE COMMUNICATIONS HANDBOOK, CRC PRESS, Boca Raton 1997

[5] WO 94/10747

[6] B. Walke, Mobilfunknetze und ihre Protokolle, Band 2, Teubner Verlag, Stuttgart 2000

**Patentansprüche**

1. Phasenregelkreis mit einem Nachlaufoszillator (VCO), dessen Ausgangssignal ($f_{out}$), das bei geöffnetem Regelkreis modulierbar ist, in einem Phasendetektor (PD) mit einem Referenzsignal ($f_{ref}$) verglichen wird, dessen Ausgangssignal $u\varphi$ über einen der Öffnung des Regelkreises dienenden Schalter (SW) sowie ein Schleifenfilter (LF) einem ersten Eingang ($in_{tune}$) des Nachlaufoszillators (VCO) zuführbar ist, **dadurch gekennzeichnet, dass** eine Kompensationseinheit (CMP) vorgesehen ist, von der dem Schleifenfilter (LF) oder dem ersten oder einem zweiten Eingang ($in_{tune}$, $in_{mod}$) des Nachlaufoszillators (VCO) ein Kompensationssignal ($s_{cmp}$) bei geöffnetem Regelkreis zuführbar ist, durch das bei geöffnetem Regelkreis auftretende Signalverschiebungen kompensierbar sind.

2. Phasenregelkreis nach Anspruch 1, **dadurch gekennzeichnet, dass** eine Steuereinheit (CU) vorgesehen ist, die zur Abgabe eines Steuersignals ($s_{cu}$) dient, mittels dessen die Kompensationseinheit (CMP), der Schalter (SW) sowie eine mit dem ersten oder dem zweiten Eingang ($in_{tune}$, $in_{mod}$) des Nachlaufoszillators (VCO) verbundene Modulationseinheit (M) derart miteinander synchronsierbar sind, dass der Regelkreis für die Dauer des Modulationsintervalls geöffnet und auftretende Signalverschiebungen mittels des Kompensationssignals ($s_{cmp}$) kompensiert werden.

3. Phasenregelkreis nach Anspruch 2, **dadurch gekennzeichnet,**

   a) dass das Kompensationssignal ($s_{cmp}$) bzw. ein Kompensationsstrom ($i_{cmp}$) dem Eingang ($in_{LF}$) des Schleifenfilters (LF) oder einem Filterbauteil des Schleifenfilters (LF) zuführbar ist oder

   b) dass eine mit dem ersten Eingang ($in_{tune}$) des Nachlaufoszillators (VCO) verbundene erste Additionsstufe (ADD1) vorgesehen ist, der das Kompensationssignal ($s_{cmp}$) bzw. ein Kompensationsstrom ($i_{cmp}$) und das Ausgangssignal ($u_f$) des Schleifenfilters (LF) zur Summenbildung zuführbar sind oder

   c) dass eine mit dem zweiten Eingang ($in_{mod}$) des Nachlaufoszillators (VCO) verbundene zweite Additionsstufe (ADD2) vorgesehen ist, in der das Kompensationssignal ($s_{cmp}$) bzw. eine Kompensationsspannung ($u_{cmp}$) und das Ausgangssignal ($s_m$) der Modulationseinheit (M) summierbar sind.

4. Phasenregelkreis nach Anspruch 1, 2 oder 3, **dadurch gekennzeichnet, dass** das Kompensationssignal $s_{cmp}$ eine sich linear ändernde Spannung ($u_{cmp}$) ist, die gesteuert durch die Steuereinheit (CU), mittels eines in der Kompensationseinheit (CMP) vorgesehenen Rampengenerators (RG) während des Modulationsintervalls erzeugt wird.

5. Phasenregelkreis nach Anspruch 4, **dadurch gekennzeichnet, dass** die Steilheit der vom Rampengenerator (RG) abgegebenen, sich linear ändernden Spannung ($u_{cmp}$) mittels eines Justiersignals $s_{adj}$ einstellbar ist, das gegebenenfalls anhand eines ersten Digital/Analog-Wandlers (D/A1) in eine Stellspannung ($V_{adj}$) umwandelbar ist.

6. Phasenregelkreis nach einem der Ansprüche 1 bis 5, **dadurch gekennzeichnet, dass** der Rampengenerator (RG) eine Brückenschaltung (R1, R2, R3, R4) aufweist, deren oberer Anschluss über einen parallel zu einem ersten Schalter ($T_{R1}$) geschalteten ersten Kondensator ($C_{R1}$) mit einer Betriebsspannung ($V_{ref}$), deren unterer Anschluss über einen parallel zu einem zweiten Schalter ($T_{R2}$) geschalteten zweiten Kondensator ($C_{R2}$) mit Masse, deren erster Mittelanschluss mit der Stellspannung ($V_{adj}$) und deren zweiter Mittelanschluss, an dem die sich linear ändernde Spannung ($u_{cmp}$) gebildet wird, mit dem Ausgang (out$_R$) des Rampengenerators (RG) verbunden ist, wobei die beiden Schalter ($T_{R1}$, $T_{R2}$) mittels der Steuereinheit (CU) für die Dauer des Modulationsintervalls geöffnet werden können.

7. Phasenregelkreis nach Anspruch 5 oder 6, **dadurch gekennzeichnet, dass** eine mit einem Temperaturfühler (TS) versehene Temperaturkompensationseinheit (TCMP) vorgesehen ist, die zur Abgabe einer der Kompensation von Temperatureinflüssen dienendes analoges oder digitales Korrektursignal Korrekturspannung ($V_{tc}$) geeignet ist, die in einer dritten Additionsstufe (ADD3) mit der Stellspannung $V_{adj}$ summiert und dem Rampengenerator (RG) zugeführt wird.

8. Phasenregelkreis nach einem der Ansprüche 5 bis 7, **dadurch gekennzeichnet, dass** der Temperaturfühler (TS) mit einem Digital-Thermometer (DTM) verbunden ist, dessen Ausgangssignal einem Codewandler (ROM) zuführbar und darin ein entsprechender Korrekturwert $s_{tc}$ ablesbar ist, der gegebenenfalls nach Digital/Analog-Wandlung mit dem Justiersignal ($s_{adj}$) summiert wird.

9. Phasenregelkreis nach einem der Ansprüche 4 bis 8, **dadurch gekennzeichnet, dass** die sich linear ändernde Spannung $u_{cmp}$ an einen Kondensator ($C_{cmp}$) angelegt wird, von dem der Kompensationsstrom ($i_{cmp}$) abgegeben wird.

10. Verfahren zum Betrieb des Phasenregelkreis nach einem der Ansprüche 1 bis 9, **dadurch gekennzeichnet, dass** eine Kompensationseinheit (CMP) vorgesehen ist, die dem Schleifenfilter (LF) oder dem ersten oder zweiten Eingang (in$_{tune}$, in$_{mod}$) des Nachlaufoszillators (VCO) des Phasenregelkreises ein Kompensationssignal ($s_{cmp}$) bei geöffnetem Regelkreis zuführt, durch das bei geöffnetem Regelkreis auftretende Signalverschiebungen kompensiert werden.

11. Verfahren nach Anspruch 10, **dadurch gekennzeichnet**,

   a) dass das Kompensationssignal ($s_{cmp}$) dem Eingang (in$_{LF}$) des Schleifenfilters (LF) oder einem Filterbauteil des Schleifenfilters (LF) zugeführt wird oder

   b) dass eine mit dem ersten Eingang (in$_{tune}$)

des Nachlaufoszillators (VCO) verbundene erste Additionsstufe (ADD1) vorgesehen ist, in der das Kompensationssignal ($s_{cmp}$) und das Ausgangssignal $u_f$ des Schleifenfilters (LF) summiert werden oder

   c) dass eine mit dem zweiten Eingang (in$_{mod}$) des Nachlaufoszillators (VCO) verbundene zweite Additionsstufe (ADD2) vorgesehen ist, in der das Kompensationssignal ($s_{cmp}$) und das Ausgangssignal ($s_m$) der Modulationseinheit (M) summiert werden.

12. Verfahren nach Anspruch 10 oder 11, **dadurch gekennzeichnet, dass** das Kompensationssignal ($s_{cmp}$) mittels eines Rampengenerators (RG) gebildet wird, der in Abhängigkeit eines von der Steuereinheit (CU) abgegebenen Steuersignals ($s_{cu}$) während Modulationsintervallen eine sich linear ändernde Spannung ($s_{cmp}$) erzeugt, deren Steilheit mittels eines Justiersignals $s_{adj}$ eingestellt wird, das gegebenenfalls anhand eines ersten Digital/Analog-Wandlers (D/A1) in eine Stellspannung ($V_{adj}$) umgewandelt wird.

13. Verfahren nach Anspruch 10, 11 oder 12, **dadurch gekennzeichnet, dass** eine mit einem Temperaturfühler (TS) versehene Temperaturkompensationseinheit (TCMP) vorgesehen ist, die eine der Kompensation von Temperatureinflüssen dienende Korrekturspannung ($V_{tc}$) abgibt, die in einer dritten Additionsstufe (ADD3) mit dem Stellsignal ($V_{adj}$) summiert und dem Rampengenerator (RG) zugeführt wird.

14. Verfahren nach Anspruch 10, 11, 12 oder 13, **dadurch gekennzeichnet, dass** mittels des Kompensationssignals ($s_{cmp}$) im Schleifenfilter (LF) auftretende Leckströme ausgeglichen oder kompensiert werden.

15. Kommunikationsgerät, insbesondere eine mit mehreren Trägerfrequenzen arbeitende Feststation, für Mobilfunkoder drahtlose Kommunikationssysteme wie das DECT-System, mit einem Phasenregelkreis nach einem der Ansprüche 1-9.

**Claims**

1. Phase locked loop comprising a voltage controlled oscillator (VCO), whose output signal ($f_{out}$), which can be modulated when the control loop is open, is compared with a reference signal ($f_{ref}$) in a phase detector (PD), whose output signal ($u\varphi$) can be forwarded via a switch (SW), that serves for opening the control loop, and via a loop filter (LF) to a first input (in$_{tune}$) of the voltage controlled oscillator (VCO), **characterised in that** a compensation unit (CMP) is provided, from which a compensation signal ($s_{cmp}$) can be forwarded to the loop filter (LF) or to the first or to a second input ($in_{tune}$, $in_{mod}$) of the voltage controlled oscillator (VCO) when the control loop is open, by which signal shifts that occur when the control loop is open can be compensated.

2. Phase locked loop according to claim 1, **characterised in that** a control unit (CU) is provided, that serves for delivering a control signal ($s_{cu}$), by which the compensation unit (CMP), the switch (SW) as well as a modulation unit (M), that is connected to the first or to the second input ($in_{tune}$, $in_{mod}$) of the voltage controlled oscillator (VCO), can be synchronised in such a way with one another, that for the duration of the modulation interval the control loop is opened and occurring signal shifts are compensated by means of the compensation signal ($s_{cmp}$).

3. Phase locked loop according to claim 2, **characterised in,**

   a) that the compensation signal ($s_{cmp}$) or a compensation current ($i_{cmp}$) can be forwarded to the input ($in_{LF}$) of the loop filter (LF) or to a filter element of the loop filter (LF), or

   b) that a first summation stage (ADD1), that is connected to the first input ($in_{tune}$) of the voltage controlled oscillator (VCO), is provided, to which the compensation signal ($s_{cmp}$) or a compensation current ($i_{cmp}$) and the output signal ($u_f$) of the loop filter (LF) can be forwarded for summation, or

   c) that a second summation stage (ADD2), that is connected to the second input ($in_{mod}$) of the voltage controlled oscillator (VCO), is provided, in which the compensation signal ($s_{cmp}$) or a compensation voltage ($u_{cmp}$) and the output signal ($s_m$) of the modulation unit (M) can be summed up.

4. Phase locked loop according to claim 1, 2 or 3, **characterised in that** the compensation signal ($s_{cmp}$) is a linear changing voltage ($u_{cmp}$), which, controlled by the control unit (CU), is created during the modulation interval by means of a ramp generator (RG) that is located in the compensation unit (CMP).

5. Phase locked loop according to claim 4, **characterised in that** the slope of the linear changing voltage ($u_{cmp}$) provided by the ramp generator (RG) is adjustable by means of an adjustment signal $s_{adj}$, that, if required, is convertible into a set voltage ($V_{adj}$) by means of a first digital/analog-converter (D/A1).

6. Phase locked loop according to one of the claims 1 to 5, **characterised in that** the ramp generator (RG) comprises a bridge circuit (R1, R2, R3, R4), whose upper connection is connected via a first capacitor ($C_{R1}$), that is connected in parallel to a first switch ($T_{R1}$), to a supply voltage ($V_{ref}$), whose lower connection is connected via a second capacitor ($C_{R2}$), that is connected in parallel to a second switch ($T_{R2}$), to ground, whose first intermediate connection is connected to the set voltage ($V_{adj}$) and whose second intermediate connection, on which the linear changing voltage ($u_{cmp}$) is created, is connected to the output ($out_R$) of the ramp generator (RG), whereas both of the switches ($T_{R1}$, $T_{R2}$) can be opened for the duration of the modulation interval by means of the control unit (CU).

7. Phase locked loop according to claim 5 or 6, **characterised in that** a temperature compensation unit (TCMP) with a temperature sensor (TS) is provided, which is designed to provide an analog or digital correction voltage ($V_{tc}$) that serves for the compensation of temperature influences and that, in a third summation stage (ADD3), is summed up with the set voltage $V_{adj}$ before it is guided to the ramp generator (RG).

8. Phase locked loop according to one of the claims 5 to 7, **characterised in that** temperature sensor (TS) is connected to a digital-thermometer (DTM), whose output signal can be forwarded to a code converter (ROM), in which a corresponding correction value ($s_{tc}$) can be read out, that, if required after digital/analog-conversion, is summed up with the adjustment signal ($s_{adj}$).

9. Phase locked loop according to one of the claims 4 to 8, **characterised in that,** that the linear changing voltage $u_{cmp}$ is applied to a capacitor ($C_{cmp}$), which supplies the compensation current ($i_{cmp}$).

10. Method for operating the phase locked loop according to one of the claims 1 to 9, **characterised in that**, that a compensation unit (CMP) is provided, which forwards a compensation signal ($s_{cmp}$), that compensates signal shifts that occur when the control loop is open, to the loop filter (LF) or to the first or to the second input ($in_{tune}$, $in_{mod}$) of the voltage controlled oscillator (VCO) of the phase locked loop, when the control loop is open.

11. Method according to claim 10, **characterised in**

   a) that the compensation signal ($s_{cmp}$) is forwarded to the input ($in_{LF}$) of the loop filter (LF) or to a filter element of the loop filter (LF), or

   b) that a first summation stage (ADD1), that is connected to the first input ($in_{tune}$) of the voltage controlled oscillator (VCO), is provided, in which the compensation signal ($s_{cmp}$) and the output signal $u_f$ of the loop filter (LF) are summed up, or

c) that a second summation stage (ADD2), that is connected to the second input ($in_{mod}$) of the voltage controlled oscillator (VCO), is provided, in which the compensation signal ($s_{cmp}$) and the output signal ($s_m$) of the modulation unit (M) are summed up.

**12.** Method according to claim 10 or 11, **characterised in that** the compensation signal ($s_{cmp}$) is built by means of a ramp generator (RG), which, depending on a control signal ($s_{cu}$) provided the control unit (CU), creates during modulation intervals a linear changing voltage ($u_{cmp}$), whose slope is adjusted by means of an adjustment signal $s_{adj}$, that, if required, is converted to a set voltage ($V_{adj}$) by means of a first digital/analog-converter (D/A1).

**13.** Method according to claim 10, 11 or 12, **characterised in that** a temperature compensation unit (TCMP) with a temperature sensor (TS) is provided, which provides a correction voltage ($V_{tc}$) that is used for the compensation of temperature influences and that, in a third summation stage (ADD3), is summed up with the set signal ($V_{adj}$) before it is guided to the ramp generator (RG).

**14.** Method according to claim 10, 11, 12 or 13, **characterised in that** by means of the compensation signal ($s_{cmp}$) leak currents, that occur in the loop filter (LF), are equalised or compensated.

**15.** Communication device, in particular, a fixed station for mobile or wireless communications systems such as the DECT-System, operating with a plurality of carrier frequencies and comprising a phase locked loop according to one of the claims 1-9.

## Revendications

**1.** Circuit de réglage de phase avec un oscillateur commandé en tension (VCO), dont le signal de sortie ($f_{out}$), qui est modulable lorsque le circuit de réglage est ouvert, est comparé dans un détecteur de phase (PD) à un signal de référence ($f_{ref}$), dont le signal de sortie $U\varphi$ via un commutateur (SW) servant d'ouverture du circuit de réglage, ainsi qu'un filtre en boucle (LF), peut être acheminé vers une première entrée ($in_{tune}$) de l'oscillateur commandé en tension (VCO), **caractérisé en ce qu'**une unité de compensation (CMP) est prévue, par laquelle un signal de compensation ($S_{cmp}$), lorsque le circuit de réglage est ouvert, peut être acheminé vers le filtre en boucle (LF) ou la première ou une seconde entrée ($in_{tune}$, $in_{mod}$) de l'oscillateur commandé en tension (VCO), par lequel des déphasages de signaux apparaissant lorsque le circuit de réglage est ouvert peuvent être compensés.

**2.** Circuit de réglage de phase selon la revendication 1, caractérisé en qu'une unité de commande (CU) est prévue, qui sert à l'émission d'un signal de commande ($S_{cu}$), au moyen duquel l'unité de compensation (CMP), le commutateur (SW) ainsi qu'une unité de modulation (M) reliée à la première ou à la seconde entrée ($in_{tune}$, $in_{mod}$) de l'oscillateur commandé en tension (VCO) peuvent être synchronisés les uns aux autres, de sorte que le circuit de réglage est ouvert pendant la durée de l'intervalle de modulation, et les déphasages de signaux qui apparaissent sont compensés au moyen du signal de compensation ($S_{cmp}$).

**3.** Circuit de réglage de phase selon la revendication 2, **caractérisé en ce que**

a) le signal de compensation ($S_{cmp}$) et/ou un courant de compensation ($i_{cmp}$) est acheminé vers l'entrée ($in_{LF}$) du filtre en boucle (LF) ou un composant de filtre du filtre en boucle (LF) ou

b) un premier étage additionneur (ADD1) relié à la première entrée ($in_{tune}$) de l'oscillateur commandé en tension (VCO) est prévu, auquel peuvent être acheminés le signal de compensation ($S_{cmp}$) et/ou un courant de compensation ($i_{cmp}$) et le signal de sortie ($u_f$) du filtre en boucle (LF) pour la formation de la somme ou

c) un second étage additionneur (ADD2) relié à la seconde entrée ($in_{mod}$) de l'oscillateur commandé en tension (VCO) est prévu, dans lequel le signal de compensation ($S_{cmp}$) et/ou une tension de compensation ($u_{cmp}$) et le signal de sortie ($S_m$) de l'unité de modulation (M) peuvent être additionnés.

**4.** Circuit de réglage de phase selon la revendication 1, 2 ou 3, caractérisé en que le signal de compensation $S_{cmp}$ est une tension ($U_{cmp}$) se modifiant linéairement qui, commandée par l'unité de commande (CU), est produite au moyen d'un générateur de rampe (RG) prévu dans l'unité de compensation (CMP) pendant l'intervalle de modulation.

**5.** Circuit de réglage de phase selon la revendication 4, caractérisé en que la pente de la tension ($u_{cmp}$) se modifiant linéairement émise par le générateur de rampe (RG) est réglable au moyen d'un signal d'ajustage $S_{adj}$ qui peut être éventuellement converti au moyen d'un premier convertisseur numérique/analogique (D/A1) en une tension de réglage ($V_{adj}$).

6. Circuit de réglage de phase selon l'une des revendications 1 à 5, **caractérisé en ce que** le générateur de rampe (RG) comprend un circuit en pont (R1, R2, R3, R4) dont le raccordement supérieur est relié via un premier condensateur ($C_{R1}$) commuté parallèlement à un premier commutateur ($T_{R1}$) à une tension de service ($V_{ref}$), dont le raccordement inférieur est relié via un second condensateur ($C_{R2}$) commuté parallèlement à un second commutateur ($T_{R2}$) à la masse, dont le premier raccordement intermédiaire est relié à la tension de réglage ($V_{adj}$), et dont le second raccordement intermédiaire sur lequel est formée la tension ($U_{cmp}$) se modifiant linéairement, est relié à la sortie ($out_R$) du générateur de rampe (RG), les deux commutateurs ($T_{R1}$, $T_{R2}$) pouvant être ouverts au moyen de l'unité de commande (CU) pendant la durée de l'intervalle de modulation.

7. Circuit de réglage de phase selon la revendication 5 ou 6, **caractérisé en ce qu'**une unité de compensation de température (TCMP) dotée d'un capteur thermique (TS) est prévue, laquelle est adaptée à l'émission d'une tension de correction ($V_{tc}$) de signal de correction analogique ou numérique utilisé pour la compensation des influences de températures qui est additionnée dans un troisième étage additionneur (ADD3) avec la tension de réglage $V_{adj}$ et est acheminée vers le générateur de rampe (RG).

8. Circuit de réglage de phase selon l'une des revendications 5 à 7, **caractérisé en ce que** le capteur thermique (TS) est relié à un thermomètre numérique (DTM) dont le signal de sortie peut être acheminé vers un convertisseur de code (ROM) dans lequel une valeur de correction $s_{to}$ correspondante est lisible, laquelle est additionnée éventuellement après la conversion numérique/analogique avec le signal de réglage ($S_{adj}$).

9. Circuit de réglage de phase selon l'une des revendications 4 à 8, **caractérisé en ce que** la tension se modifiant linéairement $U_{cmp}$ est appliquée à un condensateur ($C_{cmp}$) d'où est émis le courant de compensation ($i_{cmp}$).

10. Procédé de fonctionnement du circuit de réglage de phase selon l'une des revendications 1 à 9, **caractérisé en ce qu'**une unité de compensation (CMP) est prévue, qui achemine un signal de compensation ($S_{cmp}$), lorsque le circuit de réglage est ouvert, vers le filtre en boucle (LF) ou la première ou seconde entrée ($in_{tune}$, $in_{mod}$) de l'oscillateur commandé en tension (VCO) du circuit de réglage de phase, par lequel des déphasages de signaux qui apparaissent lorsque le circuit de réglage est ouvert sont compensés.

11. Procédé selon la revendication 10, **caractérisé en ce que** :

a) le signal de compensation ($s_{cmp}$) est amené à l'entrée ($in_{LF}$) du filtre en boucle (LF) ou à un composant de filtre du filtre en boucle (LF) ou
b) un premier étage additionneur (ADD1) relié à la première entrée ($in_{tune}$) de l'oscillateur commandé en tension (VCO) est prévu, dans lequel le signal de compensation ($s_{cmp}$) et le signal de sortie $u_f$ du filtre en boucle (LF) sont additionnés ou
c) un second étage additionneur (ADD2) relié à la seconde entrée ($in_{mod}$) de l'oscillateur commandé en tension (VCO) est prévu, dans lequel le signal de compensation ($s_{cmp}$) et le signal de sortie ($s_m$) de l'unité de modulation (M) sont additionnés.

12. Procédé selon la revendication 10 ou 11, **caractérisé en ce que** le signal de compensation ($s_{cmp}$) est formé au moyen d'un générateur de rampe (RG) qui produit, en fonction d'un signal de commande ($s_{cu}$) émis par l'unité de commande (CU) pendant des intervalles de modulation, une tension se modifiant linéairement ($s_{cmp}$) dont la pente est ajustée au moyen d'un signal d'ajustage $s_{adj}$ qui est converti éventuellement au moyen d'un premier convertisseur numérique/analogique (D/A1) en une tension de réglage ($V_{adj}$).

13. Procédé selon la revendication 10, 11 ou 12, **caractérisé en ce qu'**une unité de compensation de température (TCMP) dotée d'un capteur thermique (TS) est prévue, laquelle émet une tension de correction ($V_{tc}$) utilisée pour la compensation des influences de températures, laquelle est additionnée dans un troisième étage additionneur (ADD3) avec le signal de réglage ($V_{adj}$) et est acheminée vers le générateur de rampe (RG).

14. Procédé selon la revendication 10, 11, 12 ou 13, **caractérisé en ce que** des courants de fuite apparaissant dans le filtre en boucle (LF) sont équilibrés ou compensés au moyen du signal de compensation ($S_{cmp}$).

15. Dispositif de communication, en particulier une station fixe fonctionnant avec plusieurs fréquences porteuses, pour les systèmes de communication mobiles ou sans fil comme le système DECT, avec un circuit de réglage de phase selon l'une des revendications 1 à 9.

**Figur 1**

**Figur 2**

1 slot = 480 bits = 416 µs

downlink

uplink

1 frame = 24 slots = 11520 bits = 10 ms

**Figur 3**

$T_C = 42\ \mu s$

| | 0 | 1 | 2 | 3 | 4 |
|---|---|---|---|---|---|
| $f_9$ | | | | | |
| $f_8$ | | ▨ | | | |
| $f_7$ | | | | | |
| $f_6$ | | | ▨ | | |
| $f_5$ | | | | | |
| $f_4$ | | | | ▨ | |
| $f_3$ | | | | | |
| $f_2$ | ▨ | | | | |
| $f_1$ | | | | | |
| $f_0$ | | | | | ▨ |

slot 0 = 417 μs

**Figur 4**

1 slot = 480 bits = 417 μs

| | 0 | 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 |
|---|---|---|---|---|---|---|---|---|---|---|---|---|---|---|---|---|---|---|---|---|---|---|---|---|
| $f_9$ | | | | | | | | | | | | | | | | | | | | | | | | |
| $f_8$ | | | | | | | | | | | | | | | | | | | | | | | | |
| $f_7$ | | | | | | | | | | | | | | | | | | | | | | | | |
| $f_6$ | | | | | | | | | | | | | | | | | | | | | | | | |
| $f_5$ | | | | | | | | | | | | | | | | | | | | | | | | |
| $f_4$ | | | | | | | | | | | | | | | | | | | | | | | | |
| $f_3$ | | | | | | | | | | | | | | | | | | | | | | | | |
| $f_2$ | | | | | | | | | | | | | | | | | | | | | | | | |
| $f_1$ | | | | | | | | | | | | | | | | | | | | | | | | |
| $f_0$ | | | | | | | | | | | | | | | | | | | | | | | | |

**Figur 5**

| slot 0 = 417 μs | slot 1 = 417 μs |
|---|---|

$f_9$
$f_8$
$f_7$
$f_6$
$f_5$
$f_4$
$f_3$

$2\Delta f = 576$ kHz

$f_2$
$f_1$
$f_0$

| 0 | 1 | 2 | 3 | 4 |
|---|---|---|---|---|

**Figur 6**

C-Plane

Lower Layer Management Entity (LLME)

Network Layer (NWK)

U-Plane

Data Link Control Layer (DLC)

Data Link Control Layer (DLC)

Medium Access Control Layer (MAC)

Physical Layer (PHL)

**Figur 7**

**Figur 8**

**Figur 9**

**Figur 10**

17

**Figur 11**

**Figur 14**

**Figur 12**

**Figur 13**